Europäisches Patentamt

European Patent Office

Office européen des brevets

(19)

(11) Publication number: **0 026 518**
**A1**

(12) **EUROPEAN PATENT APPLICATION**

(21) Application number: **80200850.8**

(22) Date of filing: **11.09.80**

(51) Int. Cl.³: **G 11 C 19/08**

(30) Priority: **28.09.79 NL 7907217**

(43) Date of publication of application:
**08.04.81 Bulletin 81/14**

(84) Designated Contracting States:
**DE FR GB NL SE**

(71) Applicant: **N.V. Philips' Gloeilampenfabrieken**
**Pieter Zeemanstraat 6**
**NL-5621 CT Eindhoven(NL)**

(72) Inventor: **Enz, Ulrich Ernst**
**c/o INT. OCTROOIBUREAU B.V. Prof. Holstlaan 6**
**NL-5656 AA Eindhoven(NL)**

(74) Representative: **Koppen, Jan et al,**
**INTERNATIONAAL OCTROOIBUREAU B.V. Prof.**
**Holstlaan 6**
**NL-5656 AA Eindhoven(NL)**

(54) **Magnetic bubble domain structure.**

(57) A magnetic bubble domain structure comprising a bubble domain layer (5) supported by a non-magnetic substrate (4) and having a control layer (7) superimposed on its major surface remote from the substrate, said control layer (7) having an easy axis of magnetization in the plane of the layer which defines at least one bubble domain propagation path. Since the unique control layer according to the invention is a garnet layer which comprises two sub-layers, a first, continuous, sub-layer (8) and a second, discontinuous, sub-layer (9), the latter defining the required propagation patterns, the advantage is obtained that the in-plane rotary field to be applied for propagating the bubble domains can be considerably weaker than in bubble domain structures which are equipped with nickel-iron propagation patterns.

FIG.2

**0026518**
20.6.80

Magnetic bubble domain structure.

The invention relates to a magnetic bubble domain structure comprising a non-magnetic substrate bearing a bubble domain layer of a soft magnetic material having a positive magnetic anisotropy constant, in which layer magnetic bubble domains can be propagated, a control layer of a soft magnetic material which is superimponsed on the major surface of the bubble domain layer remote from the substrate and defines at least one bubble domain propagation path.

Magnetic bubble domain memories generally comprise one or more memory storage loops which provide accommodation for a number of single-walled magnetic domains, each of which represent one binary information bit. These bubble domains are rotated along the loop in a synchronized and controlled manner so as to enable access to the stored information. See, for example, the survey article "Bubble memories come to the boil" in Electronics, August 2, 1979, pp. 99 – 109. A number of different approaches is used in forming the bubble domain propagation paths or circuits.

In so-called "field-access" systems it is usual to define a path or track by providing on the bubble domain layer a thin film pattern which consists of a series of geometrical forms or elements of a soft magnetic nickel-iron alloy, so that, when an in-plane magnetic driving field is rotated, the elements are polarized successively positive and negative for propagation or stepwise movement of the bubble domains along the paths. Bubble domain propagation elements of nickel-iron used so far are inter alia alternate T and I shapes, alternate Y and I shapes, asymmetric chevron shapes and C-shapes.

However, a disadvantage of the use of such nickel-iron elements is that the magnetostatic interaction ("adhesive force") between bubble domains and elements
is so large that an undisturbed propagation of bubble
domains is possible only with strong rotating fields.
This "adhesive force" is related to the fact that a
bubble domain magnetizes its surroundings, notably the
nickel-iron elements. This has the same effect as a permanent magnet which is laid on an iron table.

It is the object of the invention to provide a
magnetic bubble domain structure of the kind described in
the opening paragraph in which said disturbing interaction does not occur so that a comparatively weak rotating
field is sufficient for an undisturbed propagation of
bubble domains.

This object is achieved by a bubble domain
structure which is characterized in that the control
layer has a negative magnetic anisotropy constant, and
comprises two sub-layers:

a first, continuous, sub-layer, and

a second, discontinuous, sub-layer which defines at least one bubble domain propagation path for
guiding the movement of bubble domains in the bubble
domain layer under the influence of a variation in the
oriantation of a rotating magnetic field having a direction of magnetization parallel to the plane of the bubble
domain layer, the first and second said sub-layers being
super-imposed, the one upon the other. For defining the
path or paths of propagation, the discontinuous sub-
layer may comprise propagation elements which as regards
shape correspond to the known propagation elements of
nickel-iron, for example, in the form of T and I, Y and I,
C or in the form of a chevron.

The operation of the bubble domain structure
according to the invention is based on the fact that the
rotary field magnetizes the first, continuous, sub-layer
of the control layer, the whole magnetization of the
layer co-rotating. By exchange coupling the magnetization
of the second, discontinuous, sub-control layer which defines the propagation paths is also co-rotated. The continuous sub-control layer has as it were an amplifying function, so that it is possible to use a comparatively weak rotating field, while the disturbing interaction which occurs when soft magnetic propagation elements of nickel-iron are used, is absent.

The advantages of the bubble domain structure according to the invention, as will be described in detail hereinafter, become more prominent according as the domain dimensions become smaller. In particular it is very suitable for the propagation of bubble domains having a diameter of 1 $\mu$m of smaller.

A first preferred embodiment of the bubble domain structure according to the invention is characterized in that the planar layer and the control layer are garnet layers. This presents the possibility, as will be explained hereinafter, either to form the control layer by ion implantation of the top layer of the bubble domain layer, or to grow a second garnet layer having a slightly different composition from the bubble domain layer on the bubble domain layer.

A second preferred embodiment is characterized in that the planar layer consists of a material having a magnetoplumbite structure and the control layer consists of a material which combines a hexagonal crystal structure with a negative anisotropy constant.

The invention will be described in greater detail, by way of example, with reference to the drawing, in which:

Figure 1 is a plan view of a part of a magnetic bubble domain strcuture having a bubble domain propagation structure according to the invention.

Figure 2 is a sectional view taken on the line II - II of Figure 1.

Figure 3 is a plan view of another embodiment of the invention.

Figure 4 is a sectional view taken on the line IV - IV of Figure 3.

Figure 5 is a plan view of an alternative embodiment of the invention.

Figure 6 is a sectional view taken on the line VII - VII of Figure 5.

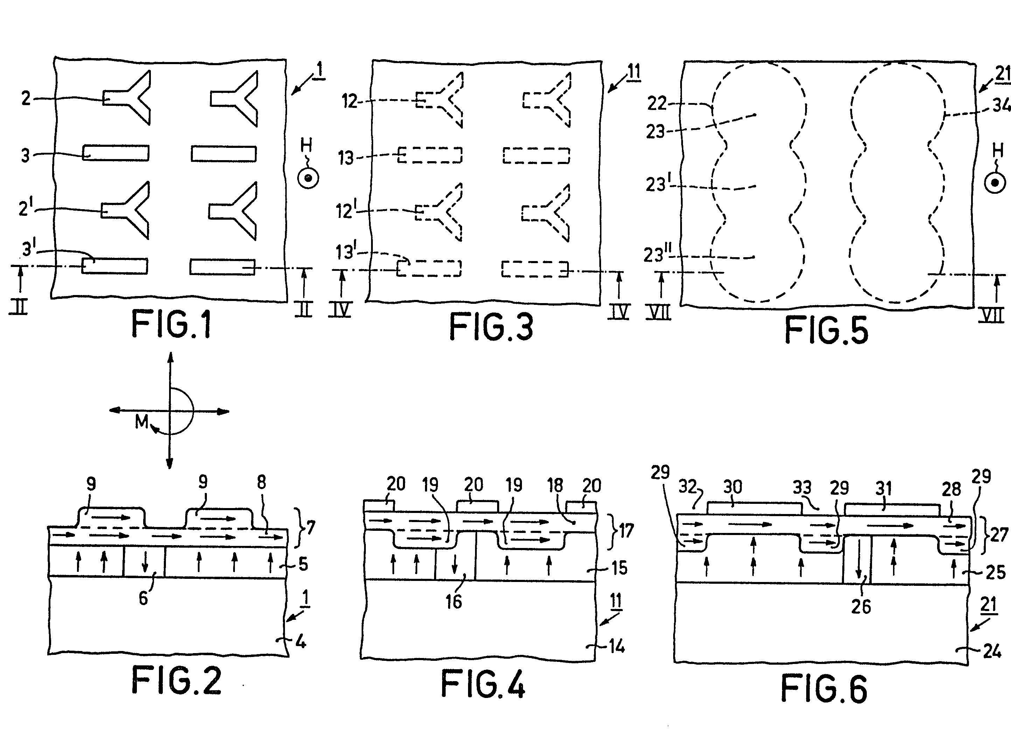

Reference numeral 1 in Figure 1 denotes a part of a magnetic bubble domain structure. It comprises a pattern of Y and I-shaped elements as denoted by 2,2' and 3,3', respectively, which define a propagation path for a magnetic bubble domain. The structure of Y-I shaped elements shown enables a movement transversely to the line II - II. However, the invention is not restricted to the use of Y and I-shaped elements. They are shown mainly for reasons of simplicity. More sophisticated elements are, for example, C-shaped elements. Whether the movement takes place in the upward direction or in the downward direction depends on the sense of rotation of a magnetic rotary field M (Figure 5) under the influence of which magnetic N and S poles are generated successively at the ends of the Y and I-shaped elements.

As shown in Figure 2, bubble domain structure 1 comprises a substrate 4 formed by a disc which is cut from a single crystal with a given orientation. A characteristic material herefor is a rare earth gallium garnet or an equivalent material. The substrate 4 supports a planar bubble domain layer 5. Characteristic herefore is an epitaxially deposited rare earth-iron garnet layer having a thickness of one or a few microns and an easy direction of magnetization in a direction perpendicular to the plane of the layer. (This means that the layer 5 has a positive magnetic anisotropy constant : $K_1 > 0$.) For illustration is shown a bubble domain 6 in the layer 5 having a direction of magnetization opposite to that of the remainder of the layer. A control layer 7 which comprises a continuous sub-layer 8 and a discontinuous sub-layer 9 is present directly on the planar layer 5. In behalf of the desired exchange coupling, the sub-layers 8 and 9 preferably each have a thickness of at most 0.5 /um (a thickness of 0.2 /um is very suitable) and have an easy direction of magnetization in the plane of the layer. (This means that the layers 8 and 9 have a negative magnetic anisotropy constant: $K_2$, $K_3 < 0$).

When bubble domain structure 1 is subjected to a rotating in-plane magnetic driving field M (assuming the usual bias field H to be present at right angles to the layer 5 so as to maintain the bubble domain 6), the following will happen. The rotating field M magnetizes the continuous sub-layer 8, the whole magnetization of the sub-layer 8 co-rotating. By exchange coupling the parts of the discontinuous sub-layer 9 which are to form the propagation elements, are also co-rotated. The sub-layer 9 generates magnetic poles analogously to those of known propagation structures of soft magnetic nickel-iron alloys. The resulting interfering interaction between bubble domain and propagation element ("adhesion"), however, is absent in this case. The sub-layer 8 functions as an amplification element so that a weaker rotary field will suffice than when the conventional propagation structures are used. Since more trouble is experienced from the interfering interaction according as the bubble domains are smaller, the advantage of the present invention becomes more and more prominent according as the bubble domain dimensions become smaller. (For propagating 1 micron bubble domains, normally a rotary field of 50 to 100 Oersted is necessary. When the invention is used, rotary fields of from 10 to 20 Oersteds are sufficient.)

A structure as shown in Figures 1 and 2 can be manufactured in various manners.

According to a first method a bubble domain layer 5 is grown on a monocrystalline substrate 4, the upper part of which layer 5 is implanted with ions so as to form a control layer 7 having in-plane magnetization. The upper part of the control layer 7 is etched away locally so as to form propagation elements 2, 3 and 2', 3', respectively, which remain as islands. For the realization of small bubble domains (cross-section 1 micron and smaller) the bubble domain material must have a very high magnetic anisotropy. In that case it is difficult to

0026518

change the anisotropy constant from positive to negative by implantation.

A second method involves the direct growth of a layer with $K > 0$ on a bubble domain layer with $K < 0$. This may be done, for example, by growing by a liquid epitaxy process, in which process a bubble domain layer of nominal composition $(Y,La)_3(Fe,Ga)_5O_{12}$, the gallium content of the grown layer increases from a first value to a second value.

Where the above relates to layers having a garnet crystal structure, which applies both to the bubble domain layer and to the control layer, a third method relates to bubble domain layers of materials having a magnetoplumbite structure which in themselves have a positive anisotropy constant, a characteristic material is in this connection barium ferrite $(BaFe_{12}O_{19})$ in combination with control layers of a material having a hexagonal crystal structure and a negative anisotropy constant. A characteristic material is barium zinc ferrite $(Ba_2Zn_2Fe_{12}O_{22})$. For this purpose, there is provided on a suitable substrate first a thin layer of $BaFe_{12}O_{19}$ having an easy axis of magnetization perpendicular to the plane of the layer, and a layer of $Ba_2Zn_2Fe_{12}O_{22}$ having an easy axis of magnetization in the plane of the layer is provided on said $BaFe_{12}O_{19}$ layer.

In all these methods, the last step is to etch away locally material from the upper part of the control layer so as to form propagation elements.

In the bubble domain chip shown partly in Figures 1 and 2, the control layer is constructed so that the sub-layer 9 with the propagation pattern is separated from the layer 5 in which bubble domains are propagated by the continuous sub-layer 8. In the bubble domain chip 11 shown in Figures 3 and 4, this is just the reverse. A bubble domain layer 15 provided on a substrate 14 is provided with a control layer 17 which consists of a continuous sub-layer 18 having in-plane magnetization which is obtained by implanting the layer 15 throughout its sur-

**0026518**

face with ions down to a depth of, for example, 0.5 micron. By deeper implantation in places which correspond to a propagation pattern consisting of elements 12, 13 and 12', 13' respectively, for example down to an overall depth of 1 micron, a discontinuous sub-layer 19 is obtained having proprgation elements directly adjoining the bubble domain layer 15. The propagation of a bubble domain 16 in said layer 15 takes place in the same manner as described above in connection with the bubble domain chip 1 shown in Figures 1 and 2.

In manufacturing the bubble domain chip shown in Figures 3 and 4, ion implantation at two levels was used of a rare earth-iron garnet layer grown on the monocrystalline substrate 14 up to a thickness of 2 microns. The layer 18 (the first level) was obtained by implantation with a dose of 2 x $10^{14}$ $Ne^+$ ions per $cm^2$ at 100 KV. In order to obtain the recesses 19 (second level), implantation with a dose of $10^{14}$ $Ne^+$ ions per $cm^2$ 300-400 KV was carried out locally through apertures in a gold mask 20.

Besides being suitable for the manufacture of the combination shown in Figures 3 and 4, respectively, of a continuous sub-layer with a discontinuous sub-layer consisting of propagation elements with intermediate spaces ("gapped propagation elements"), the method of ion implantation at two levels is also very suitable for the manufacture of a combination of a continuous sub-layer with a discontinuous sub-layer consisting of propagation elements without intermediate spaces ("contiguous propagation elements") as shown in Figures 6 and 7.

Figure 6 shows a part of a bubble domain chip 21 having a bubble domain propagation path 22 which is formed by the circumference of overlapping propagation elements 23, 23' and 23". As shown in Figure 7, bubble domain chip 21 comprises a monocrystalline substrate 24 on which a bubble domain layer 25 is grown. The upper part of the layer 25 is implanted with ions at two levels so as to obtain a bipartite control layer 27 according to the invention. During a first implantation step the area of the layer 27 is implanted with a dose of, for example, $10^{14}$ $Fe^+$ ions per $cm^2$ so as to form a continuous sub-layer 28 with in-plane magnetization. During a second implantation step the layer 25 has been implanted with the same dose down to a larger depth _via_ apertures 32, 33 etc. in a thin gold mask 30, 31 (200 nm thick) provided after the first step, so as to form a discontinuous sub-layer 29 with in-plane magnetization consisting of the local recesses of the layer 28. In other words: the sub-layer 29 has been formed with in-plane magnetization having therein a propagation pattern of overlapping elements 23, 23', 23" with an easy axis of magnetization perpendicular to the plane of the layer. In such a configuration when the exchange coupling between the sub-layers 28 and 29 does not dominate, so-called charged walls can be formed, under the influence of an in-plane magnetic field, which emanate radially from the circumference of the propagation elements. When the bubble domain chip 21 is subjected to an in-plane rotary field M (Figure 5) the charged walls co-rotate so that bubble domain 26 is also propagated.

In itself this does not differ from what happens in so-called contiguous disc bubble domains (see for example IEEE Transactions on Magnetics, Vol. MAG. 13, No. 6, November 1977, _pp._ 1944-64). However, the unique continuous sub-layer 28 with in-plane magnetization of the inventive bubble domain structure ensures that the range of the chargedwalls is restricted so that the propagation of bubble domains along an adjacent bubble domain path 34 is not disturbed, not even when it is closed. In the known contiguous disc bubble domain devices, the charged walls have a large range so that the bubble domain path cannot be located very close together.

CLAIMS:

1.        A magnetic bubble domain structure comprising a non-magnetic substrate bearing a bubble domain layer of a soft magnetic material having a positive magnetic anisotropy constant in which layer magnetic bubble domains can be propagated, a control layer of soft magnetic material which is superimposed on the major surface of the bubble domain layer remote from the substrate and defines at least one bubble domain propagation path, characterized in that the control layer has a negative magnetic anisotropy constant and comprises two sub-layers:

a first, continuous, sub-layer and

a second, discontinuous, sub-layer which defines at least one bubble domain propagation path for guiding the movement of bubble domains in the bubble domain layer under the influence of a variation in the orientation of a rotating magnetic field having a field direction parallel to the plane of the bubble domain layer, the first and second said sub-layers being super-imposed, the one upon the other.

2.        A bubble domain structure as claimed in Claim 1, characterized in that the bubble domain layer and the sub-layers of the control layer are of a material having a garnet structure.

3.        A bubble domain structure as claimed in Claim 2, characterized in that the control layer is an ion-implanted garnet layer having the same composition as the bubble domain layer.

4.        A bubble domain structure as claimed in Claim 2, characterized in that the control layer is a garnet layer having a composition which differs from that of the bubble domain layer.

5.        A bubble domain structure as claimed in Claim 1.

0026518

characterized in that the bubble domain layer consists of a material having a magneto-plumbite crystal structure and the control layer consists of a material which combines a hexagonal crystal structure with a negative magnetic anisotropy constant.

FIG.1

FIG.2

FIG.3

FIG.4

FIG.5

FIG.6

PHN 9594

European Patent
Office

**EUROPEAN SEARCH REPORT**

Application number

EP 80 20 0850

| | DOCUMENTS CONSIDERED TO BE RELEVANT | | CLASSIFICATION OF THE APPLICATION (Int. Cl.³) |
|---|---|---|---|
| Category | Citation of document with indication, where appropriate, of relevant passages | Relevant to claim | |
| | FR - A - 2 296 910 (I.B.M.) <br><br> * Page 7, lines 16-30; page 9, lines 3-34; figures 3,5A * <br><br> -- | 1,3 | G 11 C 19/08 |
| | FR - A - 2 256 508 (I.B.M.) <br><br> * Page 3, line 30 - page 6, line 37; figures 1,2 * <br><br> -- | 1 | |
| | US - A - 4 006 276 (ROCKWELL INTERNATIONAL CORPORATION) <br><br> * Column 3, line 42 - column 4, line 4; figures 3,4 * <br><br> ---- | 1 | |

TECHNICAL FIELDS
SEARCHED (Int. Cl.³)

G 11 C 19/08

CATEGORY OF
CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 05-01-1981 | DEGRAEVE |

EPO Form 1503.1  06.78